(19) Europäisches Patentamt
European Patent Office
Office européen des brevets

(11) **EP 4 633 347 A1**

(12) **EUROPEAN PATENT APPLICATION**
published in accordance with Art. 153(4) EPC

(43) Date of publication:
**15.10.2025 Bulletin 2025/42**

(21) Application number: **23900444.3**

(22) Date of filing: **21.11.2023**

(51) International Patent Classification (IPC):
**H10N 10/817** (2023.01)  **C22C 23/00** (2006.01)
**C22F 1/06** (2006.01)  **H10N 10/01** (2023.01)
**H10N 10/852** (2023.01)

(52) Cooperative Patent Classification (CPC):
**C22C 23/00; C22F 1/06; H10N 10/01;
H10N 10/817; H10N 10/852**

(86) International application number:
**PCT/JP2023/041705**

(87) International publication number:
**WO 2024/122325 (13.06.2024 Gazette 2024/24)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **08.12.2022 JP 2022196647**

(71) Applicant: **Panasonic Intellectual Property
Management Co., Ltd.
Kadoma-shi, Osaka 571-0057 (JP)**

(72) Inventors:
• **KAWABE, Takeshi
Kadoma-shi, Osaka 571-0057 (JP)**
• **TAMAKI, Hiromasa
Kadoma-shi, Osaka 571-0057 (JP)**
• **ASANO, Hiroki
Kadoma-shi, Osaka 571-0057 (JP)**

(74) Representative: **Grünecker Patent- und
Rechtsanwälte
PartG mbB
Leopoldstraße 4
80802 München (DE)**

(54) **THERMOELECTRIC CONVERSION ELEMENT, THERMOELECTRIC CONVERSION MODULE, THERMOELECTRIC CONVERSION SYSTEM, ELECTRIC POWER GENERATION METHOD, THERMOELECTRIC CONVERSION MATERIAL, AND METHOD FOR MANUFACTURING THERMOELECTRIC CONVERSION ELEMENT**

(57)     The present disclosure provides a thermoelectric conversion element that is advantageous in terms of decreasing an electrical resistance of thermoelectric conversion elements. According to the present disclosure, a thermoelectric conversion element (10a) includes a thermoelectric conversion layer (11) and a metal layer (12). The thermoelectric conversion layer (11) includes a thermoelectric conversion material containing Mg and at least one selected from the group consisting of Sb and Bi. The thermoelectric conversion layer (11) includes a first surface (11a), which is in contact with the metal layer (12). In an instance where a cross section of the thermoelectric conversion layer (11) and the metal layer (12) in a thickness direction of the metal layer (12) is observed by energy dispersive X-ray spectroscopy (EDX), an arithmetic mean roughness Ra of the first surface (11a) in the cross section satisfies a condition expressed as $Ra \leq 4.2$ μm.

FIG. 1

**Description**

BACKGROUND

1. Technical Field

The present disclosure relates to a thermoelectric conversion element, a thermoelectric conversion module, a thermoelectric conversion system, a thermoelectric conversion material, a method for generating electrical power, and a method for manufacturing a thermoelectric conversion element.

2. Description of the Related Art

In the related art, thermoelectric conversion elements are known. For example, an N-type thermoelectric conversion element including an N-type thermoelectric conversion material can be electrically connected to a P-type thermoelectric conversion element including a P-type thermoelectric conversion material to provide a thermoelectric conversion module. A known approach for facilitating the electrical connection between thermoelectric conversion elements is to form a layer of a metal material on an end surface portion of the thermoelectric conversion material. In an instance where the end surface portion of the thermoelectric conversion material is formed of a layer of a metal material, the thermoelectric conversion element is easy to handle and to assemble.

Patent Literature 1, for example, describes a magnesium-antimony-based thermoelectric element. This thermoelectric element includes a magnesium-antimony-based thermoelectric material substrate layer positioned in the center of the thermoelectric element, transition layers attached to two surfaces of the substrate layer, and electrode layers attached to surfaces of the two transition layers. The transition layers are made of a magnesium-copper alloy and/or a magnesium-aluminum alloy. The transition layers are formed by a magnetron sputtering method or a thermal spraying method.

Patent Literature 2 describes a magnesium-antimony-based thermoelectric element. This thermoelectric element includes a magnesium-antimony-based thermoelectric material substrate layer positioned in the center of the thermoelectric element, transition layers attached to two surfaces of the substrate layer, and electrode layers attached to surfaces of the two transition layers. The transition layers are made of a titanium-copper alloy or a magnesium-copper alloy. The transition layers are formed by an ion beam sputtering method or a magnetron sputtering method.

Patent Literature 3 describes a thermoelectric conversion element including electrodes, intermediate layers, and a thermoelectric conversion layer. The intermediate layers are each provided between the thermoelectric conversion layer and the electrode. The intermediate layers are in contact with the thermoelectric conversion layer. The thermoelectric conversion layer contains Mg, at least one element selected from the group consisting of Sb and Bi, and at least one element selected from the group consisting of Se and Te. The electrodes are composed of a CuZn alloy. The composition of the intermediate layers are different from the composition of the electrodes and the composition of the thermoelectric conversion layer. The intermediate layers contain Cu, Zn, and Mg. The intermediate layers are formed by a spark plasma sintering method (SPS).

Patent Literature 4 describes roughening surfaces of a thermoelectric element and an electrode, thereby decreasing interface resistance. Examples of the material of the thermoelectric element include bismuth telluride, cesium bismuth telluride, and bismuth antimony.

Non-Patent Literature 1 describes a contact resistivity at a contact interface between $Mg_3Sb_{1.5}Bi_{0.5}$ and a thermoelectric boundary material, such as Fe, Ni, Mg, Cu, Al, Zn, Ag, or Ti.

CITATION LIST

Patent Literature
PTL 1: Chinese Patent No. 111613715
PTL 2: Chinese Patent No. 110635020
PTL 3: International Publication No. 2020/003554
PTL 4: Japanese Unexamined Patent Application Publication (Translation of PCT Application) No. 2022-523127

Non-Patent Literature

NPL 1: X. Wu et. al., Acta Mater. 226 117616 (2022)

SUMMARY

(Technical Problem)

The present disclosure provides a thermoelectric conversion element that is advantageous in terms of decreasing an electrical resistance of thermoelectric conversion elements.

(Solution to Problem)

According to the present disclosure, a thermoelectric conversion element comprises a thermoelectric conversion layer that comprises a thermoelectric conversion material comprising Mg and at least one selected from the group consisting of Sb and Bi; and a metal layer, wherein the thermoelectric conversion layer comprises a first surface that is in contact with the metal layer, and in an instance where a cross section of the thermoelectric conversion layer and the metal layer in a thickness direction of the metal layer is observed by energy dispersive X-ray spectroscopy, an arithmetic mean roughness Ra of the first surface in the cross section satisfies a first condition expressed as Ra ≤ 4.2 $\mu$m.

(Advantageous Effects of Invention)

The present disclosure can provide a thermoelectric conversion element that is advantageous in terms of decreasing an electrical resistance of thermoelectric conversion elements.

BRIEF DESCRIPTION OF DRAWINGS

[Fig. 1] Fig. 1 is a schematic cross-sectional view illustrating a thermoelectric conversion element of a first embodiment.
[Fig. 2] Fig. 2 is a schematic diagram illustrating a $La_2O_3$-type crystal structure.
[Fig. 3] Fig. 3 is a flowchart illustrating an exemplary process for calculating an arithmetic mean roughness Ra.
[Fig. 4] Fig. 4 is an exemplary image showing a distribution of Mg in a cross section of a thermoelectric conversion element.
[Fig. 5] Fig. 5 is a binarized image obtained from the image shown in Fig. 4, the binarized image being a denoised image.
[Fig. 6] Fig. 6 is a flowchart illustrating a method for manufacturing the thermoelectric conversion element of the first embodiment.
[Fig. 7] Fig. 7 is a cross-sectional view illustrating an exemplary thermoelectric conversion module of a second embodiment.
[Fig. 8] Fig. 8 is a cross-sectional view illustrating another exemplary thermoelectric conversion module of the second embodiment.
[Fig. 9] Fig. 9 is a cross-sectional view illustrating yet another exemplary thermoelectric conversion module of the second embodiment.
[Fig. 10] Fig. 10 is a side view illustrating a thermoelectric conversion system of a third embodiment.
[Fig. 11] Fig. 11 is a schematic diagram illustrating a manner of measuring an electrical resistance of a thermoelectric conversion element.
[Fig. 12] Fig. 12 is a graph showing exemplary results of measuring the electrical resistance of the thermoelectric conversion element of the working example 1.
[Fig. 13] Fig. 13 is a photograph showing a thermoelectric conversion element of the working example 1.
[Fig. 14] Fig. 14 is a photograph showing peeling of a plated film of the comparative example 3.

DESCRIPTION OF EMBODIMENTS

(Underlying Knowledge Forming Basis of the Present Disclosure)

Possible methods for forming a metal layer include electrolytic plating and electroless plating. Regarding the joining of dissimilar materials, in general, in an instance where an interface between the dissimilar materials is roughened, an anchoring effect is produced, which is expected to improve adhesion between the dissimilar materials.
As an example, a metal layer containing Cu or the like may be formed, by a method such as plating, on an end surface of a thermoelectric conversion layer including a thermoelectric conversion material containing Mg and at least one selected from the group consisting of Sb and Bi. Studies conducted by the present inventors found that in the instance, if the arithmetic mean roughness Ra of the end surface of the thermoelectric conversion layer is high, interface resistance at the interface between the thermoelectric conversion layer and the metal layer tends to increase. In addition, the present inventors found that if the arithmetic mean roughness Ra of the end surface of the thermoelectric conversion layer is high, adhesion of the metal layer to the thermoelectric conversion layer decreases, which results in peeling of the metal layer.

Patent Literature 1, 2, and 3 describe some materials that can serve as the metal layer that is to be in contact with the end surface of the thermoelectric conversion layer including a thermoelectric conversion material containing Mg and at least one selected from the group consisting of Sb and Bi. Patent Literature 1, 2, and 3, however, do not discuss the surface conditions of the end surface of the thermoelectric conversion layer that is to be in contact with the metal layer. Patent Literature 4 states that the interface resistance can be decreased by roughening the surface of a thermoelectric element including a material such as bismuth telluride. Non-Patent Literature 1 describes a contact resistivity at a contact interface between $Mg_3Sb_{1.5}Bi_{0.5}$ and a thermoelectric boundary material, such as Fe, Ni, Mg, Cu, Al, Zn, Ag, or Ti; however, Non-Patent Literature 1 fails to discuss the surface conditions of the $Mg_3Sb_{1.5}Bi_{0.5}$ at the contact interface.

Accordingly, the present inventors made numerous trial-and-error attempts to solve the problems that may occur in the instance where a metal layer containing, for example, Cu is formed on the end surface of the thermoelectric conversion layer including a thermoelectric conversion material containing Mg and at least one selected from the group consisting of Sb and Bi. As a result, the present inventors newly discovered that in an instance where the roughness of a first surface of the thermoelectric conversion layer that is to be in contact with the metal layer is adjusted, the interface resistance at the interface between the thermoelectric conversion layer and the metal layer is decreased, which is advantageous in terms of decreasing an electrical resistance of thermoelectric elements. Based on this new finding, the present inventor completed the thermoelectric conversion element of the present disclosure.

(Embodiments of the Present Disclosure)

Embodiments of the present disclosure will be described below with reference to the drawings.

(First Embodiment)

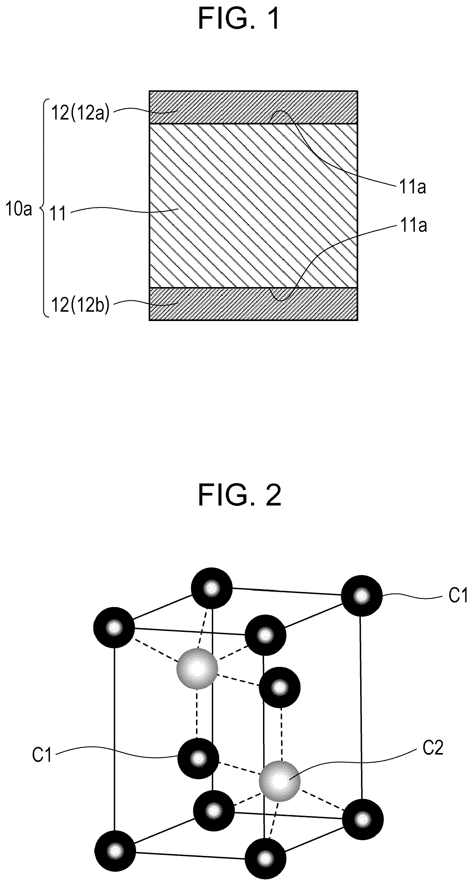

Fig. 1 is a schematic cross-sectional view illustrating a thermoelectric conversion element of a first embodiment. As illustrated in Fig. 1, a thermoelectric conversion element 10a includes a thermoelectric conversion layer 11 and a metal layer 12. The thermoelectric conversion layer 11 includes a thermoelectric conversion material containing Mg and at least one selected from the group consisting of Sb and Bi. The thermoelectric conversion layer 11 includes a first surface 11a, which is in contact with the metal layer 12. In an instance where a cross section of the thermoelectric conversion layer 11 and the metal layer 12 in a thickness direction of the metal layer 12 is observed by energy dispersive X-ray spectroscopy (EDX), an arithmetic mean roughness Ra of the first surface 11a in the cross section satisfies a condition expressed as $Ra \leq 4.2\ \mu m$. Consequently, an interface resistivity at an interface between the thermoelectric conversion layer 11 and the metal layer 12 is likely to be decreased, for example. In addition, in an instance where the metal layer 12 is formed by a method such as plating, adhesion of the metal layer 12 to the thermoelectric conversion layer 11 is likely to increase, which makes it unlikely that peeling of the metal layer 12 occurs.

The arithmetic mean roughness Ra of the first surface 11a is not limited to any particular value as long as the above-mentioned condition is satisfied. For example, the arithmetic mean roughness Ra of the first surface 11a is greater than or equal to 0.05 $\mu m$. In this instance, the time it takes to adjust the arithmetic mean roughness Ra of the first surface 11a can be shortened. The arithmetic mean roughness Ra may be greater than or equal to 0.1 $\mu m$, greater than or equal to 0.15 $\mu m$, or greater than or equal to 0.2 $\mu m$.

The arithmetic mean roughness Ra of the first surface 11a may be within a range defined by the upper limit value mentioned below and the lower limit value mentioned below. The upper limit value is, for example, a value selected from the group consisting of 4.2 $\mu m$, 4.0 $\mu m$, 3.5 $\mu m$, 3.0 $\mu m$, 2.5 $\mu m$, and 2.0 $\mu m$. The lower limit value is a value selected from the group consisting of 0.05 $\mu m$, 0.1 $\mu m$, 0.15 $\mu m$, and 0.2 $\mu m$.

The shape of the thermoelectric conversion element 10a is not limited to any particular shape. For example, the thermoelectric conversion element 10a is generally rectangular-parallelepiped-shaped. The shape of the thermoelectric conversion element 10a may be any shape in which the thermoelectric conversion layer 11 containing a thermoelectric conversion material can be formed. The shape may be, for example, a rectangular parallelepiped shape, a cubic shape, a generally cubic shape, any other prismatic shape, a generally prismatic shape, a cylindrical shape, or a tubular shape.

The thermoelectric conversion layer 11 has a thickness that is not limited to any particular value. The thickness is, for example, greater than or equal to 0.1 mm and less than or equal to 5.0 mm.

The thermoelectric conversion material that is included in the thermoelectric conversion layer 11 is not limited to any particular material as long as the thermoelectric conversion material contains Mg and at least one selected from the group consisting of Sb and Bi. For example, the thermoelectric conversion material that is included in the thermoelectric conversion layer 11 is an N-type thermoelectric conversion material.

The thermoelectric conversion material that is included in the thermoelectric conversion layer 11 has, for

example, a $La_2O_3$-type crystal structure. In this instance, the thermoelectric conversion element 10a is likely to exhibit desired thermoelectric properties. Whether the thermoelectric conversion material has a $La_2O_3$-type crystal structure can be determined, for example, based on the results of an X-ray diffraction measurement of a sample of the thermoelectric conversion material. Fig. 2 is a schematic diagram illustrating a $La_2O_3$-type crystal structure. In an instance where the thermoelectric conversion material has a $La_2O_3$-type crystal structure, an example is as follows: referring to Fig. 2, Mg is positioned at a C1 site, and at least one selected from the group consisting of Sb and Bi is positioned at a C2 site. As illustrated in Fig. 2, a bond, indicated by the dashed line, is formed between the C1 site and the C2 site.

The thermoelectric conversion material, for example, further contains Te. In this instance, the thermoelectric conversion element 10a is more likely to exhibit desired thermoelectric properties.

The thermoelectric conversion material has, for example, a composition represented by $Mg_{3+m}R_aT_bSb_{2-e-c}Bi_cZ_e$. In this composition, the element R is at least one element selected from the group consisting of Ca, Sr, Ba, and Yb. The element T is at least one element selected from the group consisting of Mn and Zn. The element Z is at least one element selected from the group consisting of Te, Se, Sc, Y, and La. The value of m satisfies $-0.39 \leq m \leq 0.42$. The value of a satisfies $0 \leq a \leq 0.12$. The value of b satisfies $0 \leq b \leq 0.48$. The value of c satisfies $0 \leq c \leq 1.6$. The value of e satisfies $0.001 \leq e \leq 0.06$. In this instance, the thermoelectric conversion element 10a is more likely to exhibit desired thermoelectric properties.

As illustrated in Fig. 1, the metal layer 12 constitutes, for example, an end surface of the thermoelectric conversion element 10a. In an example of the thermoelectric conversion element 10a, the metal layer 12 includes a first metal layer 12a and a second metal layer 12b, and the first metal layer 12a and the second metal layer 12b are disposed such that the first metal layer 12a and the second metal layer 12b constitute both end surfaces of the thermoelectric conversion element 10a in the thickness of the metal layer 12. The thickness of the metal layer 12 is not limited to any particular value. The thickness is, for example, greater than or equal to 0.5 $\mu$m and less than or equal to 100 $\mu$m and is desirably greater than or equal to 0.5 $\mu$m and less than or equal to 10 $\mu$m. The thicknesses of the metal layers 12 may be the same as or different from each other.

The metal that is included in the metal layer 12 is not limited to any particular metal. For example, the metal layer 12 contains Cu. In the metal layer 12, the Cu may be present as elemental Cu or an alloy containing Cu. In this instance, the thermoelectric conversion element 10a is more likely to exhibit desired thermoelectric properties.

Diffusion of a metal may occur between the metal layer 12 and the thermoelectric conversion layer 11. In an instance where the metal layer 12 includes an alloy containing Cu, the alloy may contain, for example, Cu and at least one selected from the group consisting of Mg, Sb, Bi, Te, and Zn. The Mg, Sb, Bi, Te, and Zn are derived from the thermoelectric conversion layer 11. A portion resulting from the diffusion of a metal that occurs between the metal layer 12 and the thermoelectric conversion layer 11 may be formed in only one of the first metal layer 12a and the second metal layer 12b or in both of the first metal layer 12a and the second metal layer 12b.

The thermoelectric conversion element 10a may include an additional layer, such as an electrode layer for, for example, establishing connection to an electrical circuit and preventing oxidation of an electrode. The additional layer may be disposed on a surface that is not in contact with the first surface 11a in the thickness direction of the metal layer 12. The additional layer may be a single layer or multiple layers. An example of the additional layer is a layer having a structure in which a Ni layer and an Au layer are formed in this order on the metal layer 12 in the thickness direction of the metal layer 12. Regarding the electrode layer that is formed on the first metal layer 12a or the second metal layer 12b, the composition of the material, the structure of the layers, and the thickness of the layers may be the same as or different from each other. A diffusion layer may or may not be present between layers.

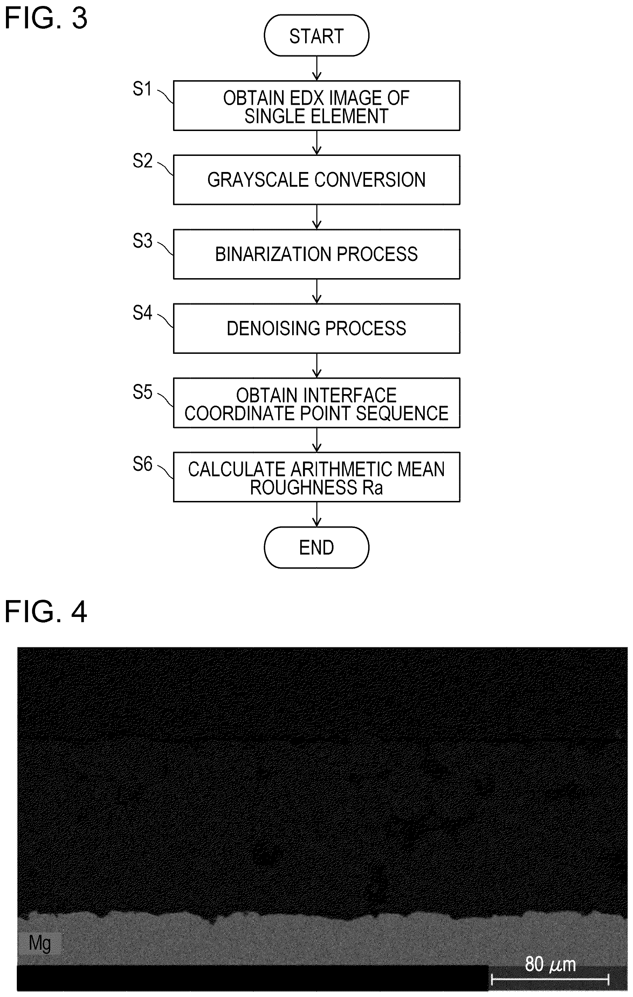

Fig. 3 is a flowchart illustrating an exemplary process for calculating the arithmetic mean roughness Ra of the first surface 11a of the thermoelectric conversion layer 11. As illustrated in Fig. 3, in step S1, a cross section of the thermoelectric conversion layer 11 and the metal layer 12 in the thickness direction of the metal layer 12 is observed by energy dispersive X-ray spectroscopy (EDX) to obtain an EDX image of a single element. The EDX image may be obtained, for example, with a field emission scanning electron microscope (FE-SEM) (model number: SU8220), manufactured by Hitachi High-Tech Corporation, and a Quantax FlatQUAD, manufactured by Bruker AXS. Prior to EDX, a process for smoothing the cross section of the thermoelectric conversion layer 11 and the metal layer 12 may be performed with a method such as ion milling.

In step S1, the single element that is selected to obtain the EDX image is not limited to any particular element. For example, the single element may be Mg, Sb, or Bi that can be included in the thermoelectric conversion layer 11 or may be Cu that can be included in the metal layer 12. In the EDX image, a size of one pixel is, for example, a half or less of the arithmetic mean roughness Ra of the first surface 11a. In addition, a size of the field of view for the EDX image is, for example, sufficiently larger than the arithmetic mean roughness Ra of the first surface 11a. A representative dimension of the field of view for the EDX image is desirably 10 times or more the value of the arithmetic mean roughness Ra of the first surface 11a and more desirably 100 times or more the value. Fig. 4 is an exemplary image obtained by EDX and showing a distribution of Mg in a cross section of the thermoelectric conversion element.

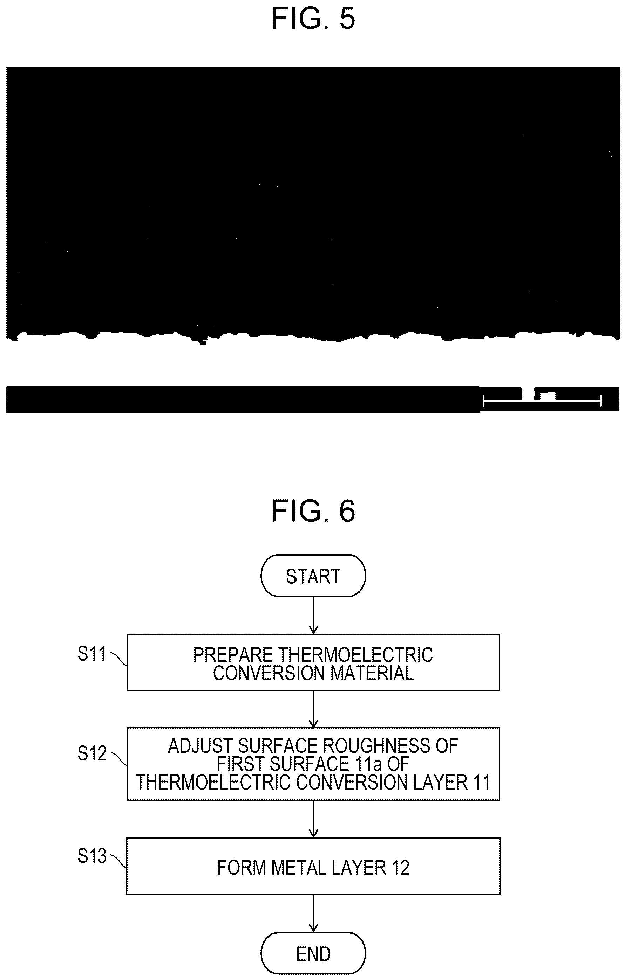

The processes in step S2 and subsequent steps can be carried out, for example, with an OpenCV Python library or the like. In step S2, a grayscale conversion process is performed on the EDX image obtained in step S1, to provide a grayscale image. Next, in step S3, a binarization process is performed on the grayscale image based on a predetermined brightness threshold value, to provide a binary image. In an instance where the EDX image is an image showing a distribution of, for example, Mg as the single element, the brightness threshold value is selected such that a boundary between the portion containing Mg and the portion not containing Mg becomes clear. Next, in step S4, a denoising process is performed on the obtained binary image. The denoising process may be performed, for example, such that small white dots in the black region or small black dots in the white region are removed. Desirably, a denoising process that may be employed is a process in which a pair of processes is performed once or twice. The pair of processes is referred to as a closing-opening process and composed of dilation and erosion. Fig. 5 is a binary image obtained from the image shown in Fig. 4, the binary image being a denoised image.

Next, in step S5, an interface coordinate point sequence is obtained from the denoised binary image. In the binary image shown in Fig. 5, for example, x and y are defined as follows: x represents coordinates corresponding to respective pixels in a left- and-right direction (horizontal direction) and is based on actual sizes, and y represents coordinates corresponding to respective pixels in an up-and-down direction and is based on the actual sizes. For each of the $x_n$ values (n = 1, 2, ... N, where N is the number of pixels in the horizontal direction), a white-black boundary position $y_n$ is determined to provide the interface coordinate point sequence. If multiple boundary positions $y_n$ are determined for one $x_n$ value, one boundary position $y_n$ is to be selected for the determination of the interface coordinate point sequence, in accordance with the concept of a stylus evaluation method described in Japanese Industrial Standards JIS B 0601:2013 and JIS B 0633:2001. For example, when the EDX image is an image regarding Mg, Sb, or Bi, a $y_n$ value closest to the metal layer 12 is to be selected from among the multiple boundary positions $y_n$ for the determination of the interface coordinate point sequence. When the EDX image is an image regarding Cu, a $y_n$ value closest to the thermoelectric conversion layer 11 is to be selected from among the multiple boundary positions $y_n$ for the determination of the interface coordinate point sequence.

Next, in step S6, the arithmetic mean roughness Ra of the first surface 11a is calculated according to equation (1), which will be shown below, by using the interface coordinate point sequence obtained in step S5. The function f(x) is expressed as f(x) = ax + b and can be obtained by approximating the interface coordinate point sequence ($x_n$, $y_n$) with a linear function. The function f(x) is used to correct a deviation from a horizontal state if the obtained EDX image is not completely horizontal because of influence of the selection of the field of view. The arithmetic mean roughness Ra of the first surface 11a is determined in this manner, for example. The calculation of the arithmetic mean roughness Ra may be performed on multiple locations, in cross sections of one thermoelectric conversion element 10a that extend in the same direction, and the arithmetic mean roughness Ra of the first surface 11a may be determined as an average of the obtained calculated values.

[Math. 1]

$$\mathrm{R\,a} = (1/\mathrm{N}) \sum_{n=1}^{N} |\, y_n - f\,(x_n)\,| \qquad \text{equation (1)}$$

An example of correspondence relationships between the arithmetic mean roughness Ra determined based on the EDX image and the arithmetic mean roughness Ra measured in accordance with the JIS Standards mentioned above is shown in Table 1. The arithmetic mean roughness Ra based on the JIS Standards is a measured value of the end surface of the thermoelectric conversion layer 11 that corresponds to the first surface 11a and which is a surface before the metal layer 12 is formed thereon. According to Table 1, the arithmetic mean roughness Ra determined based on the EDX image has a correlation function of 0.9 or greater with the arithmetic mean roughness Ra measured in accordance with the JIS Standards, which indicates that a strong positive correlation exists between these arithmetic mean roughnesses Ra.

[Table 1]

| Value of Ra Determined by Measurement Method in Accordance with JIS Standards | Value of Ra Determined by Method Described in Present Disclosure |
|---|---|
| 5.54 μm | 4.48 μm |
| 3.41 μm | 4.16 μm |
| 1.35 μm | 1.61 μm |
| 0.76 μm | 0.75 μm |
| 0.59 μm | 0.50 μm |
| 0.18 μm | 0.22 μm |

Relationships between the arithmetic mean roughnesses Ra in each of the instances in which the single element selected in obtaining the EDX image was Mg, Sb, Bi, or Cu, regarding one thermoelectric conversion element 10a, are shown in Table 2. As shown in Table 2, the determined arithmetic mean roughnesses Ra are close values regardless of the type of the single element selected in obtaining the EDX image. The method of the present disclosure for determining the arithmetic mean roughness Ra by using an EDX image can quantitatively evaluate the state of the roughness of the first surface 11a.

In general, surface roughnesses are evaluated in accordance with methods specified, for example, in JIS B 0601:2013 and JIS B 0633:2001. Regarding the manufacture of the thermoelectric conversion element 10a, the present inventors believe that the arithmetic mean roughness Ra of the first surface 11a may be affected by forming the metal layer 12 in contact with the first surface 11a. For example, in an instance where the metal layer 12 is formed by plating, the surface of the thermoelectric conversion layer 11 that corresponds to the first surface 11a may be denatured, which can have an influence on the arithmetic mean roughness Ra of the first surface 11a. Furthermore, in an instance where the metal layer 12 is formed by DC sputtering or the like, the surface of the thermoelectric conversion layer 11, which serves as the substrate, is also susceptible to damage, which can have an influence on the arithmetic mean roughness Ra of the first surface 11a. The method for determining the arithmetic mean roughness Ra by using an EDX image can quantitatively evaluate the state of the roughness of the first surface 11a, taking into account the influence of the formation of the metal layer 12 on the arithmetic mean roughness Ra of the first surface 11a.

[Table 2]

| Single Element in EDX Image | Mg | Sb | Bi | Cu |
|---|---|---|---|---|
| Arithmetic Mean Roughnesses Ra of Thermoelectric Conversion Element A | 1.61 µm | 2.03 µm | 1.84 µm | 1.79 µm |
| Arithmetic Mean Roughnesses Ra of Thermoelectric Conversion Element B | 0.22 µm | 0.32 µm | 0.32 µm | 0.29 µm |

The thermoelectric conversion element 10a can be manufactured, for example, by a method including (I) and (II), described below.

(I) Adjusting the arithmetic mean roughness Ra of the first surface 11a of the thermoelectric conversion layer 11 which includes a thermoelectric conversion material containing Mg and at least one selected from the group consisting of Sb and Bi

(II) Forming a metal layer in contact with the first surface 11a

Fig. 6 is a flowchart illustrating a method for manufacturing the thermoelectric conversion element 10a. In step S11, the thermoelectric conversion material is prepared, as illustrated in Fig. 6. An example of a method for preparing the thermoelectric conversion material is described below. Methods for preparing the thermoelectric conversion material are not limited to the method described below.

A solid-state reaction is caused between raw materials that are in a mixed state. The raw materials are Mg particles and at least one type of particles selected from the group consisting of Sb particles and Bi particles. In this way, a powdered alloy containing Mg and at least one selected from the group consisting of Sb and Bi is prepared. In the solid-state reaction, a powder of a dopant element may be mixed together as necessary. The raw materials may be particles or powders. An example of a method for causing the solid-state reaction is mechanical alloying. The alloy may be prepared by a method other than a solid-state reaction, which may be, for example, a melting method or the like.

Subsequently, the powdered alloy is sintered to form a single-crystal or polycrystalline alloy. The sintering of the powdered alloy can be accomplished, for example, by a spark plasma sintering method or a hot-press method. The resulting sintered body can be used directly as the thermoelectric conversion material. The resulting sintered body may be subjected to heat treatment, and the heat-treated sintered body may be used as the thermoelectric conversion material.

Next, in step S12, the arithmetic mean roughness Ra of the first surface 11a of the thermoelectric conversion layer 11 that includes the prepared thermoelectric conversion material is adjusted, as illustrated in Fig. 6. Step S12 corresponds to (I), which has been described above.

A method that can be used to adjust the arithmetic mean roughness Ra of the first surface 11a is, for example, a predetermined machining process. An example of the machining process is dry polishing. The arithmetic mean roughness Ra of the first surface 11a may be adjusted by cutting the thermoelectric conversion material performed with a wire saw or a blade saw, the first surface 11a being a cut surface. Washing of the thermoelectric conversion layer 11 may be performed in adjusting the arithmetic mean roughness Ra of the first surface 11a. In this way, an amount of foreign materials adhering to the first surface 11a, such as an abrasive, can be decreased, which makes it likely that adhesion between the thermoelectric conversion layer 11 and the metal layer 12 increases. The thus-obtained first surface 11a has an arithmetic mean roughness Ra that satisfies a condition expressed as Ra ≤ 5.2 μm. In this instance, the arithmetic mean roughness Ra of the first surface 11a is determined in accordance with JIS B 0601:2013 and JIS B 0633:2001. The first surface 11a is at least one surface that is to be in contact with an outside of the thermoelectric conversion material. The adjustment of the arithmetic mean roughness Ra of the first surface 11a may be performed in a manner such that the condition of Ra ≤ 4.7 μm, the condition of Ra ≤ 4.2 μm, or the condition of Ra ≤ 3.7 μm is satisfied.

Next, in step S13, the metal layer 12, which is to be in contact with the first surface 11a, is formed. Step S13 corresponds to (II), which has been described above. Methods for forming the metal layer 12 are not limited to any particular method. Examples of methods for forming the metal layer 12 include electroplating, electroless plating, sputtering, and thermal spraying. In the instance where the metal layer 12 is formed by electroplating, a commercially available plating liquid may be used. After completion of the plating, a washing process for removing the plating liquid may be performed. In this way, the thermoelectric conversion element 10a is obtained. After the metal layer 12 is formed, an additional film may be formed by a method such as electroplating, to prevent oxidation of the metal layer 12.

(Second Embodiment)

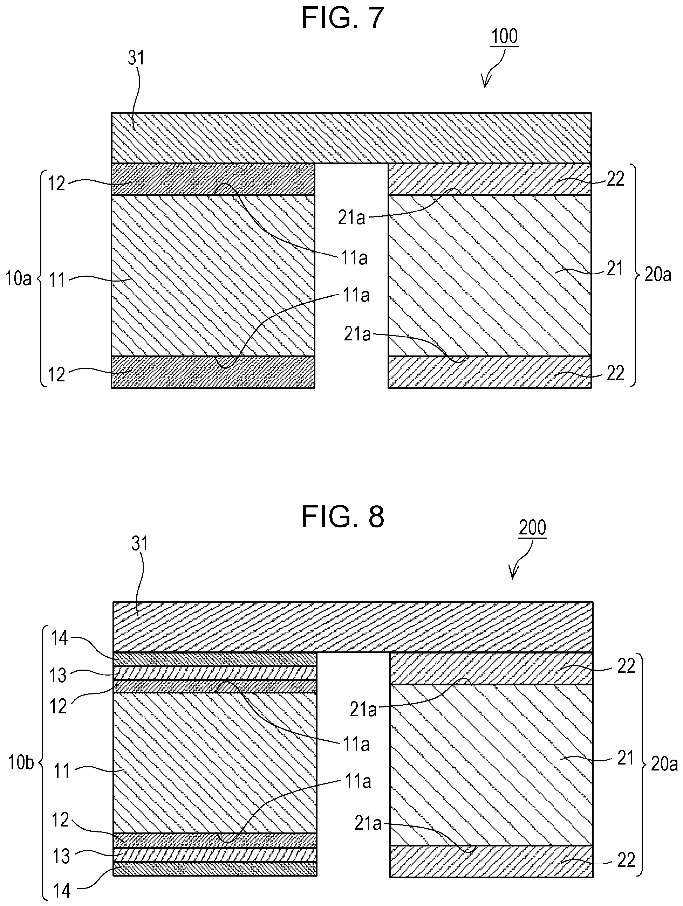

Fig. 7 is a cross-sectional view illustrating an exemplary thermoelectric conversion module of the second embodiment. As illustrated in Fig. 7, a thermoelectric conversion module 100 includes a P-type thermoelectric element 20a, an N-type thermoelectric element, which is a thermoelectric conversion element 10a, and an electrode 31. The electrode 31 electrically connects a first end portion of the P-type thermoelectric conversion element 20a to a first end portion of the N-type thermoelectric conversion element 10a. A metal layer 12 may be directly connected to the electrode 31, or another layer may be disposed between the electrode 31 and the metal layer 12.

As illustrated in Fig. 7, the P-type thermoelectric element 20a includes, for example, a thermoelectric conversion layer 21 and a pair of electrode layers 22. The electrode layers 22 are each in contact with a second surface 21a of the thermoelectric conversion layer 21. The second surfaces 21a are end surfaces of the thermoelectric conversion layer 21 in a thickness direction of the electrode layers 22. The pair of electrode layers 22 are in contact with both end surfaces of the thermoelectric conversion layer 21 in the thickness direction of the electrode layers 22. The electrode layers 22 may be directly connected to the electrode 31, or another layer may be disposed between the electrode 31 and the electrode layers 22.

The thermoelectric conversion layer 21 includes a P-type thermoelectric conversion material. Examples of the P-type thermoelectric conversion material include bismuth telluride, cesium bismuth telluride, germanium telluride, bismuth antimony, $Mg_3(Sb,Bi)_2$, and MgAgSb. "(Sb,Bi)" means that at least one selected from the group consisting of Sb and Bi is contained. The N-type thermoelectric conversion material included in a thermoelectric conversion layer 11 and the P-type thermoelectric conversion material included in the thermoelectric conversion layer 21 may be materials of the same type of alloy system or materials of different types of alloy systems. The expression "of the same type of alloy system" means having the same alloy-forming elements. From the standpoint of decreasing a thermal stress in the thermoelectric conversion module 100, it is important that the difference in a coefficient of thermal expansion between the N-type thermoelectric conversion material included in the thermoelectric conversion layer 11 and the P-type thermoelectric conversion material included in the thermoelectric conversion layer 21 be small. For example, when the P-type thermoelectric conversion material is $Mg_3(Sb,Bi)_2$ or bismuth telluride, the difference in the coefficient of thermal expansion between the N-type thermoelectric conversion material and the P-type thermoelectric conversion material tends to be small.

When the P-type thermoelectric conversion material is bismuth telluride, the electrode layers 22 are, for example, Ni-plated layers, Ni-thermal-sprayed layers, Ni-sputtered layers, Mo-thermal-sprayed layers, or the like. When the P-type thermoelectric conversion material is bismuth telluride and has a composition represented by $Bi_2Te_x$, x in this composition satisfies, for example, the condition of $2 < x < 4$. The composition of the bismuth telluride may be $Bi_2Te_3$. The bismuth telluride may contain at least one selected from the group consisting of antimony and selenium. The bismuth telluride containing antimony has a composition of, for example, $(Bi_{1-y}Sb_y)_2Te_x$. When the P-type thermoelectric conversion material has the composition of $(Bi_{1-y}Sb_y)_2Te_x$, the condition of $0 < y < 1$, for example, is satisfied, and desirably, the condition of $0.6 < y < 0.9$ is satisfied.

Fig. 8 is a cross-sectional view illustrating another exemplary thermoelectric conversion module. As illustrated in Fig. 8, a thermoelectric conversion module 200 has the same configuration as that of the thermoelectric conversion module 100, except that the N-type thermoelectric conversion element that is included is a thermoelectric conversion element 10b instead of the thermoelectric conversion element 10a. The thermoelectric conversion element 10b has the same configuration as that of the thermoelectric conversion element 10a, except for portions that are particularly described. Constituent elements of the thermoelectric conversion element 10b that are the same as or correspond to the constituent elements of the thermoelectric conversion element 10a are assigned the same reference numerals, and details thereof will not be described. The descriptions of the thermoelectric conversion element 10a apply to the thermoelectric conversion element 10b as long as there is no technical inconsistency.

As illustrated in Fig. 8, the thermoelectric conversion element 10b includes a metal layer 12, a first electrode layer 13, and a second electrode layer 14. The metal layer 12, the first electrode layer 13, and the second electrode layer 14 are disposed in this order in the thermoelectric conversion element 10b, starting from a first surface 11a of the thermoelectric conversion layer 11, in a thickness direction of the metal layer 12. The thermoelectric conversion element 10b is electrically connected to an electrode 31 with the metal layer 12, the first electrode layer 13, and the second electrode layer 14.

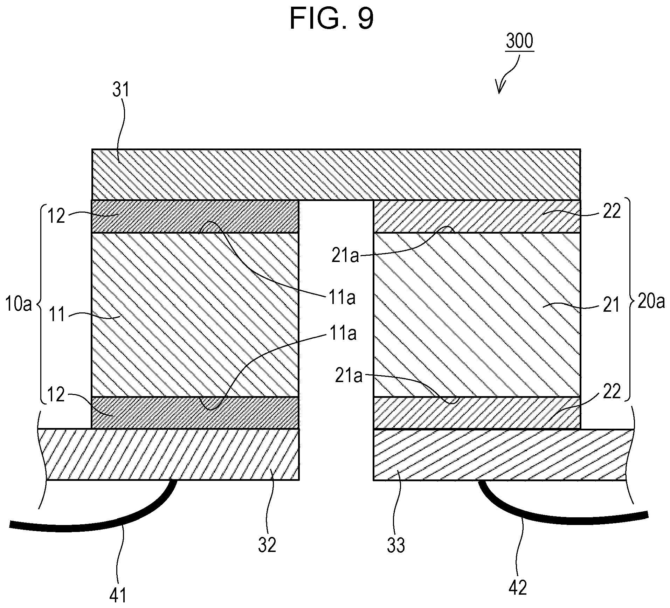

Fig. 9 is a cross-sectional view illustrating yet another exemplary thermoelectric conversion module. A thermoelectric conversion module 300, illustrated in Fig. 9, has the same configuration as that of the thermoelectric conversion module 100, except for portions that are particularly described. As illustrated in Fig. 9, the thermoelectric conversion module 300 further includes an electrode 32 and an electrode 33. A second end portion of an N-type thermoelectric conversion element 10a is electrically connected to the electrode 32 with a metal layer 12. A second end portion of a P-type thermoelectric conversion element 20a is electrically connected to the electrode 33 with an electrode layer 22. The thermoelectric conversion module 300 further includes a first wiring 41 and a second wiring 42. The first wiring 41 is connected to the electrode 32. The second wiring 42 is connected to the electrode 33. The first wiring 41 and the second wiring 42 serve to, for example, apply a voltage to the N-type thermoelectric conversion element 10a and the P-type thermoelectric conversion element 20a. The first wiring 41 and the second wiring 42 may serve to supply electricity generated in the thermoelectric conversion module 300 to an outside of the thermoelectric conversion module 100.

(Third Embodiment)

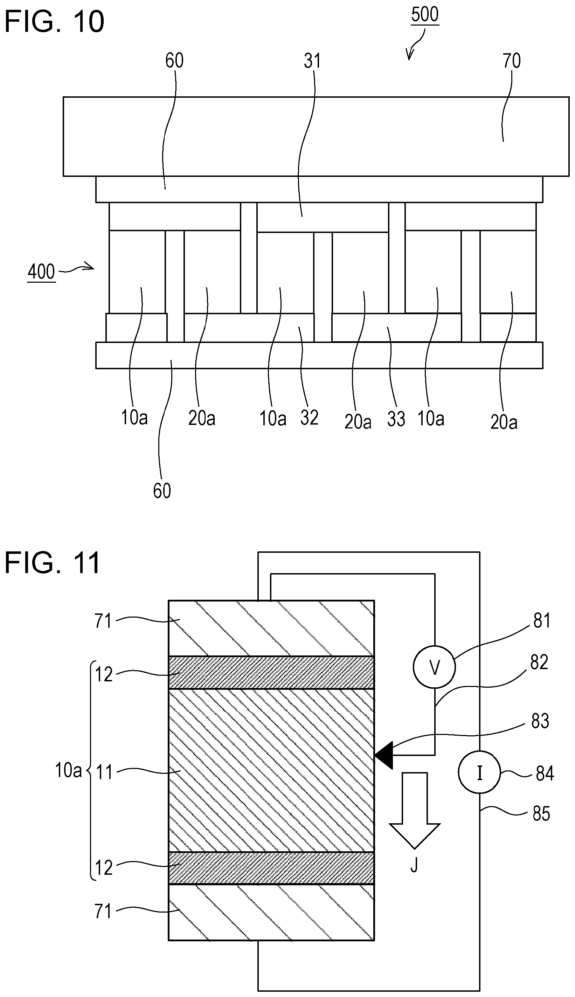

Fig. 10 is a side view illustrating a thermoelectric conversion system of the third embodiment. As illustrated in Fig. 10, a thermoelectric conversion system 500 includes a thermoelectric conversion module 400 and a heat source 70. The thermoelectric conversion module 400 has the same configuration as that of the thermoelectric conversion module 100, except for portions that are particularly described. The thermoelectric conversion module 400 includes an electrode 31, an electrode 32, and an electrode 33. The heat source 70 is disposed adjacent to the electrode 31. The electrode 32 and the electrode 33 each electrically connect a second end portion of the P-type thermoelectric conversion element 20a to a second end portion of the N-type thermoelectric conversion element 10a.

The thermoelectric conversion system 500 further includes, for example, a pair of substrates 60. One of the pair of substrates 60 is disposed in contact with the electrode 31, and the other of the pair of substrates 60 is disposed in contact with the electrode 32 and the electrode 33. This configuration makes it unlikely that temperature variations occur in a direction parallel to a major surface of the substrates 60 in the thermoelectric conversion system 500. The material of the substrates 60 is not limited to any particular material. For example, the substrates 60 contain alumina or aluminum nitride.

With the thermoelectric conversion system 500, it is possible to provide a method for generating electrical power that includes generating electrical power by applying a temperature difference to the thermoelectric conversion module 400 by using heat from the heat source 70.

The thermoelectric conversion elements of the above-described embodiments can be used in a variety of applications, including, for example, applications of thermoelectric conversion elements of the related art.

(Supplementary Notes)

the following technologies are disclosed on the basis of the above.

(Technology 1)

A thermoelectric conversion element comprising:

a thermoelectric conversion layer that comprises a thermoelectric conversion material comprising Mg and at least one selected from the group consisting of Sb and Bi; and
a metal layer, wherein
the thermoelectric conversion layer comprises a first surface that is in contact with the metal layer, and
in an instance where a cross section of the thermoelectric conversion layer and the metal layer in a thickness direction of the metal layer is observed by energy dispersive X-ray spectroscopy, an arithmetic mean roughness Ra of the first surface in the cross section satisfies a first condition expressed as $Ra \leq 4.2 \ \mu m$.

(Technology 2)

The thermoelectric conversion element according to Technology 1, wherein the metal layer comprises Cu.

(Technology 3)

The thermoelectric conversion element according to Technology 1 or 2, wherein the arithmetic mean roughness Ra of the first surface satisfies a second condition expressed as 0.05 $\mu$m $\leq$ Ra.

(Technology 4)

The thermoelectric conversion element according to any one of Technologies 1 to 3, wherein the thermoelectric conversion material has a $La_2O_3$-type crystal structure.

(Technology 5)

The thermoelectric conversion element according to any one of Technologies 1 to 3, wherein the thermoelectric conversion material further comprises Te.

(Technology 6)

The thermoelectric conversion element according to any one of Technologies 1 to 5, wherein the thermoelectric conversion material has a composition represented by $Mg_{3+m}R_aT_bSb_{2-e-c}Bi_cZ_e$, where

the element R is at least one element selected from the group consisting of Ca, Sr, Ba, and Yb,
the element T is at least one element selected from the group consisting of Mn and Zn,
the element Z is at least one element selected from the group consisting of Te, Se, Sc, Y, and La,
a value of m satisfies $-0.39 \leq m \leq 0.42$,
a value of a satisfies $0 \leq a \leq 0.12$,
a value of b satisfies $0 \leq b \leq 0.48$,
a value of c satisfies $0 \leq c \leq 1.6$, and
a value of e satisfies $0.001 \leq e \leq 0.06$.

(Technology 7)

A thermoelectric conversion module comprising:

a P-type thermoelectric conversion element;
an N-type thermoelectric conversion element; and
an electrode electrically connecting a first end portion of the P-type thermoelectric conversion element to a first end portion of the N-type thermoelectric conversion element, wherein
the N-type thermoelectric conversion element is the thermoelectric conversion element according to any one of Technologies 1 to 6.

(Technology 8)

A thermoelectric conversion system comprising:

the thermoelectric conversion module according to Technology 7; and
a heat source disposed adjacent to the electrode.

(Technology 9)

A method for generating electrical power, the method comprising generating electrical power by creating a temperature difference in the thermoelectric conversion module according to Technology 7 by using heat from the heat source.

(Technology 10)

A thermoelectric conversion material comprising Mg and at least one selected from the group consisting of Sb and Bi, wherein

the thermoelectric conversion material comprises at least one surface that is to be in contact with an outside of the thermoelectric conversion material, the at least one surface having an arithmetic mean roughness Ra that satisfies a third condition expressed as Ra ≤ 5.2 μm, and

the arithmetic mean roughness Ra is determined in accordance with JIS B 0601:2013 and JIS B 0633:2001.

(Technology 11)

A method for manufacturing a thermoelectric conversion element, the method comprising:

adjusting an arithmetic mean roughness Ra of a first surface of a thermoelectric conversion layer that comprises a thermoelectric conversion material comprising Mg and at least one selected from the group consisting of Sb and Bi; and

forming a metal layer in contact with the first surface, wherein

in an instance where a cross section of the thermoelectric conversion layer and the metal layer in a thickness direction of the metal layer is observed by energy dispersive X-ray spectroscopy, the arithmetic mean roughness Ra of the first surface in the cross section satisfies a fourth condition expressed as Ra ≤ 4.2 μm.

EXAMPLES

The present disclosure will now be described in detail with reference to Examples. Note that the thermoelectric conversion elements of the present disclosure are not limited to the Examples described below.

(Working example 1)

Approximately 1.3 g of a powder of an alloy produced by a solid-state reaction and having a composition of $Mg_{3.2}Sb_{1.5}Bi_{0.49}Te_{0.01}$ was weighed in a glove box. An argon atmosphere was maintained in the glove box until a thermoelectric conversion material was obtained. Next, the weighed powder was compacted into a sintering space in a carbon die and compressed with a carbon punch. The die had an inside diameter of 10 mm. Next, the die was placed in a chamber of a spark plasma sintering apparatus. An argon atmosphere was maintained in the chamber. Next, a current was applied to the die by the sintering apparatus while a pressure of 50 MPa was applied to the compact in the die. As a result of the application of the current, the temperature of the die reached 840°C, which was a sintering temperature, and subsequently, the temperature was maintained for 10 minutes. Subsequently, the heating of the die was discontinued by decreasing the current flowing through the die. After a decreasing in the die temperature to room temperature was observed, the sintered body was ejected from the die to provide a thermoelectric conversion material of the working example 1. A surface of the ejected thermoelectric conversion material, which was the sintered body, was polished and subsequently washed with acetone, the surface being a surface that was in contact with the interior surface of the die. The sintered body of the working example 1 had a thickness of approximately 3 mm.

Both end surfaces of the sintered body in a thickness direction thereof was polished with sandpaper. The polishing was dry polishing and was performed with a sample polishing machine IS-polisher, manufactured by Ikegami Seiki Co., Ltd. After the dry polishing, the sintered body had a thickness of approximately 2.9 mm. The arithmetic mean roughness Ra of the polished surface of the sintered body of the working example 1 was measured with a method in accordance with JIS B 0601:2013 and JIS B 0633:2001. The result was that the arithmetic mean roughness Ra of the polished surface was 3.41 μm. The measurement of the arithmetic mean roughness Ra was carried out with a Surfcom Touch 50, manufactured by Tokyo Seimitsu Co., Ltd.

Cu electroplating was performed on the polished surface of the sintered body of the working example 1 to form metal layers. After the Cu electroplating, the sintered body was washed.

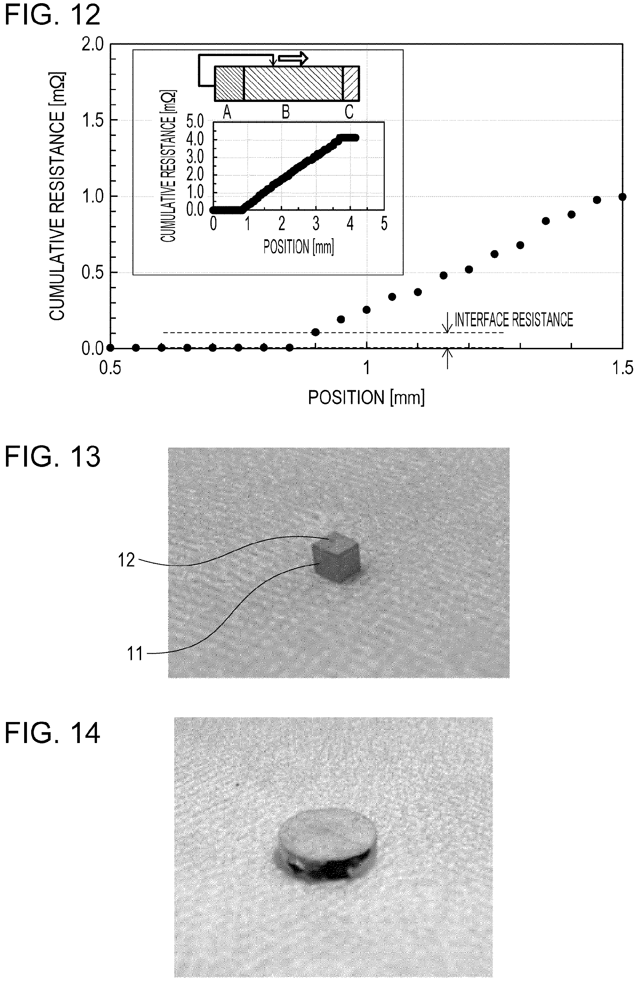

The sintered body on which the metal layers were formed was processed with a wire saw to provide a thermoelectric conversion element of the working example 1. The thermoelectric conversion element had a rectangular parallelepiped shape and had a square shape contour with a side length of approximately 3 mm in a plane parallel to the metal layers. In the thermoelectric conversion element of the working example 1, a distance between the metal layers was approximately 2.9 mm. Fig. 13 is a photograph showing the thermoelectric conversion element of the working example 1.

External electrodes were attached to the metal layers of the thermoelectric conversion element of the working example 1,and then, an aging treatment performed under use conditions of the thermoelectric conversion element of the working example 1.

The interface resistivity at the interface between the thermoelectric conversion layer, which was a sintered body, and the metal layer, in the thermoelectric conversion element of the working example 1, was determined as follows. Fig. 11 is a schematic diagram illustrating a manner of measuring an electrical resistance of a thermoelectric conversion element. As illustrated in Fig. 11, a pair of external electrodes 71 are attached to a thermoelectric conversion element 10a. An ammeter 84 is electrically connected to both of the pair of electrodes 71 with a lead 85. A voltmeter 81 is connected to one of the external electrodes 71 with a lead 82, and a probe 83 is connected to an end portion of the lead 82, the end portion being located opposite to the one of the external electrodes 71. The electrical resistance was measured with a four-terminal method, while the probe 83 was moved 50 $\mu$m each time from the one of the external electrodes 71 to the other of the external electrodes 71 in a direction indicated by an arrow J. The measurement of the electrical resistance was carried out with a source meter (model number: 2400) manufactured by Keithley Instruments, Inc. Fig. 12 is a graph showing exemplary results of measuring the electrical resistance of the thermoelectric conversion element of the working example 1. In Fig. 12, "A" is a portion corresponding to one of the metal layers 12 and the one of the external electrodes 71. "B" is a portion corresponding to the thermoelectric material layer 11. "C" is a portion corresponding to the other of the metal layers 12 and the other of the external electrodes 71. The amount of change in the electrical resistance at the boundary between A and B and the amount of change in the electrical resistance at the boundary between B and C correspond to the interface resistance at the interface between the thermoelectric conversion layer and the metal layer. The interface resistivity at the interface between the thermoelectric conversion layer and the metal layer in the thermoelectric conversion element of the working example 1 was determined from the interface resistance mentioned above and an area of a cross section of the thermoelectric conversion element of the working example 1, the cross section being parallel to the metal layer. The result was that the interface resistivity was 2.53 m$\Omega$mm$^2$.

Subsequently, argon ion milling was performed on the thermoelectric conversion element of the working example 1 in a direction perpendicular to the interface between the thermoelectric conversion layer and the metal layer, to form a smooth first cross section. The interface was exposed on the smooth first cross section. Composition analysis was performed on the smooth first cross section with a field emission scanning electron microscope (FE-SEM) (model number: SU8220), manufactured by Hitachi High-Tech Corporation and an energy dispersive X-ray analysis (EDX) instrument FlatQUAD, manufactured by Bruker AXS. Thus, an EDX image that contained the boundary between the thermoelectric conversion layer and the metal layer and in which Mg was selected as the single element was obtained. The arithmetic mean roughness Ra of the surface of the thermoelectric conversion layer, which was the surface in contact with the metal layer, was determined from the obtained EDX image, in a manner similar to the manner of calculating the arithmetic mean roughness Ra based on an EDX image described in the first embodiment. The result was that the arithmetic mean roughness Ra was 4.16 $\mu$m. In addition, argon ion milling was performed in a direction perpendicular to the interface between the thermoelectric conversion layer and the metal layer to form a smooth second cross section which was perpendicular to the first cross section. The interface was exposed on the smooth second cross section. Composition analysis of the second cross section was also performed in a manner similar to that for the first cross section. Thus, an EDX image that contained the boundary between the thermoelectric conversion layer and the metal layer and in which Mg was selected as the single element was obtained. The arithmetic mean roughness Ra of the surface of the thermoelectric conversion layer, which was the surface in contact with the metal layer, was calculated from the obtained EDX image and found to be 3.85 $\mu$m. The values listed in Table 1 are each the larger of the arithmetic mean roughness Ra calculated from the EDX image of the first cross section and the arithmetic mean roughness Ra calculated from the EDX image of the second cross section.

(Working examples 2 to 34 and Comparative examples 1 and 2)

Thermoelectric conversion materials of the working examples 2 to 34 and the comparative examples 1 and 2 were prepared in the same manner as in the working example 1, except that the composition of the alloy powders was adjusted as shown in Table 3 or Table 4. Dry polishing was performed on each of the thermoelectric conversion materials in the same manner as in the working example 1, except that the conditions for the polishing were adjusted such that the arithmetic mean roughness Ra of the polished surface became the value shown in Table 3 or 4. The arithmetic mean roughness Ra of the polished surface of the sintered body was measured in the same manner as in the working example 1. The results are shown in Table 3 or 4. As shown in Table 3 or 4, the interface resistivities at the interface between the thermoelectric conversion layer and the metal layer in the thermoelectric conversion elements of the Examples were lower than the interface resistivities at the interface between the thermoelectric conversion layer and the metal layer in the thermoelectric conversion elements of comparative examples 1 and 2.

Thermoelectric conversion elements of working examples 2 to 34 and comparative examples 1 and 2 were prepared by performing Cu electroplating and wire saw processing in the same manner as in the working example 1, except that each of the dry-polished thermoelectric conversion materials was used. The thermoelectric conversion elements were each evaluated in the same manner as the thermoelectric conversion element of the working example 1. The results are shown in Table 3 or 4.

(Comparative example 3)

A thermoelectric conversion material was prepared in the same manner as in the working example 1. Dry polishing was performed on the prepared thermoelectric conversion material in the same manner as in the working example 1, except that the conditions for the polishing were adjusted such that the arithmetic mean roughness Ra of the polished surface became the value shown in Table 4. Cu electroplating was tried in the same manner as in the working example 1, except that this dry-polished thermoelectric conversion material was used. Fig. 14 is a photograph showing peeling of a plated film of the comparative example 3. In the comparative example 3, as illustrated in Fig. 14, peeling of the plated film occurred in the washing step after the Cu electroplating, and thus, it was not possible to form the metal layer.

(Comparative example 4)

A thermoelectric conversion material of the comparative example 4 was prepared in the same manner as in the working example 1, except that an alloy powder having the composition shown in Table 4 was used. Dry polishing was performed on the prepared thermoelectric conversion material in the same manner as in the working example 1, except that the conditions for the polishing were adjusted such that the arithmetic mean roughness Ra of the polished surface became the value shown in Table 4. Cu electroplating was tried in the same manner as in the working example 1, except that this dry-polished thermoelectric conversion material was used. In the comparative example 4, however, peeling of the plated film occurred in the washing step after the Cu electroplating, and thus, it was not possible to form the metal layer.

[Table 3]

| In Table 3, "W." means Working. | | | | | |
|---|---|---|---|---|---|
| | Composition | Ra based on JIS [$\mu$m] | Ra based on EDX image [$\mu$m] | Interface Resistivity [$m\Omega mm^2$] | Notes |
| W. example 1 | $Mg_{3.2}Sb_{1.5}Bi_{0.49}Te_{0.01}$ | 3.41 | 4.16 | 2.53 | |
| W. Example 2 | $Mg_{3.2}Sb_{1.5}Bi_{0.49}Te_{0.01}$ | 1.35 | 1.61 | 2.04 | |
| W. Example 3 | $Mg_{3.2}Sb_{1.5}Bi_{0.49}Te_{0.01}$ | 0.76 | 0.75 | 1.63 | |
| W. Example 4 | $Mg_{3.2}Sb_{1.5}Bi_{0.49}Te_{0.01}$ | 0.59 | 0.50 | 0.92 | |
| W. Example 5 | $Mg_{3.2}Sb_{1.5}Bi_{0.49}Te_{0.01}$ | 0.18 | 0.22 | 0.97 | |
| W. Example 6 | $Mg_{3.2}Sb_{1.0}Bi_{0.99}Te_{0.01}$ | 3.70 | 3.32 | 3.52 | |
| W. Example 7 | $Mg_{3.2}Sb_{1.0}Bi_{0.99}Te_{0.01}$ | 1.49 | 1.44 | 2.79 | |
| W. Example 8 | $Mg_{3.2}Sb_{1.0}Bi_{0.99}Te_{0.01}$ | 1.15 | 0.76 | 2.53 | |
| W. Example 9 | $Mg_{3.2}Sb_{1.0}Bi_{0.99}Te_{0.01}$ | 0.84 | 0.69 | 2.18 | |
| W. example 10 | $Mg_{3.2}Sb_{1.0}Bi_{0.99}Te_{0.01}$ | 0.13 | 0.31 | 1.60 | |
| W. example 11 | $Mg_{3.2}Sb_{0.5}Bi_{1.49}Te_{0.01}$ | 3.04 | 3.15 | 4.60 | |
| W. example 12 | $Mg_{3.2}Sb_{0.5}Bi_{1.49}Te_{0.01}$ | 1.90 | 1.35 | 4.31 | |
| W. example 13 | $Mg_{3.2}Sb_{1.5}Bi_{0.49}Te_{0.01}Mn_{0.01}$ | 1.70 | 1.93 | 2.14 | |
| W. example 14 | $Mg_{3.2}Sb_{1.0}Bi_{0.99}Te_{0.01}Mn_{0.01}$ | 1.98 | 1.62 | 3.47 | |
| W. example 15 | $Mg_{3.2}Sb_{1.5}Bi_{0.49}Te_{0.01}Zn_{0.01}$ | 1.05 | 1.05 | 2.64 | |
| W. example 16 | $Mg_{3.2}Sb_{1.0}Bi_{0.99}Te_{0.01}Zn_{0.01}$ | 1.83 | 1.33 | 3.36 | |
| W. example 17 | $Mg_{3.1}Sb_{1.5}Bi_{0.49}Te_{0.01}$ | 1.59 | 1.70 | 2.83 | |
| W. example 18 | $Mg_{3.05}Sb_{1.5}Bi_{0.49}Te_{0.01}$ | 1.10 | 1.53 | 2.84 | |
| W. example 19 | $Mg_{3.1}Sb_{1.0}Bi_{0.99}Te_{0.01}$ | 1.31 | 1.81 | 3.50 | |
| W. example 20 | $Mg_{3.05}Sb_{0.1}Bi_{0.99}Te_{0.01}$ | 1.47 | 1.53 | 2.84 | |

[Table 4]

| | Composition | Ra based on JIS [μm] | Ra based on EDX image [μm] | Interface Resistivity [mΩmm$^2$] | Notes |
|---|---|---|---|---|---|
| In Table 4, "W." means Working. | | | | | |
| W. example 21 | $Mg_{3.2}Sb_{1.5}Bi_{0.48}Te_{0.02}$ | 1.04 | 1.71 | 2.63 | |
| W. example 22 | $Mg_{3.2}Sb_{1.5}Bi_{0.495}Te_{0.005}$ | 1.99 | 1.36 | 2.55 | |
| W. example 23 | $Mg_{3.2}Sb_{1.5}Bi_{0.497}Te_{0.003}$ | 1.10 | 1.76 | 2.73 | |
| W. example 24 | $Mg_{3.2}Sb_{1.0}Bi_{0.98}Te_{0.02}$ | 1.60 | 1.18 | 3.09 | |
| W. example 25 | $Mg_{3.2}Sb_{1.0}Bi_{0.995}Te_{0.005}$ | 1.19 | 1.28 | 3.44 | |
| W. example 26 | $Mg_{3.2}Sb_{1.0}Bi_{0.997}Te_{0.003}$ | 1.19 | 1.61 | 3.59 | |
| W. example 27 | $Mg_{3.2}Sb_{1.0}Bi_{0.995}Te_{0.005}Mn_{0.01}$ | 1.15 | 1.64 | 3.44 | |
| W. example 28 | $Mg_{3.2}Sb_{1.0}Bi_{0.997}Te_{0.003}Mn_{0.01}$ | 1.48 | 1.84 | 2.98 | |
| W. example 29 | $Mg_{3.1}Sb_{1.0}Bi_{0.995}Te_{0.005}Mn_{0.01}$ | 2.00 | 1.82 | 3.33 | |
| W. example 30 | $Mg_{3.1}Sb_{1.0}Bi_{0.997}Te_{0.003}Mn_{0.01}$ | 1.62 | 1.08 | 3.61 | |
| W. example 31 | $Mg_{3.2}Sb_{1.0}Bi_{0.995}Te_{0.005}Zn_{0.01}$ | 1.73 | 1.34 | 3.10 | |
| W. example 32 | $Mg_{3.2}Sb_{1.0}Bi_{0.997}Te_{0.003}Zn_{0.01}$ | 1.88 | 1.20 | 3.13 | |
| W. example 33 | $Mg_{3.1}Sb_{1.0}Bi_{0.995}Te_{0.005}Zn_{0.01}$ | 1.71 | 1.68 | 3.35 | |
| W. example 34 | $Mg_{3.1}Sb_{1.0}Bi_{0.997}Te_{0.003}Zn_{0.01}$ | 1.53 | 1.57 | 3.23 | |
| W. example 35 | $Mg_{3.2}Y_{0.6}Sb_{1.5}Bi_{0.49}Te_{0.01}$ | 1.93 | 1.70 | 2.88 | |
| Comparative example 1 | $Mg_{3.2}Sb_{1.5}Bi_{0.49}Te_{0.01}$ | 5.54 | 4.48 | 6.36 | |
| Comparative example 2 | $Mg_{3.2}Sb_{1.0}Bi_{0.99}Te_{0.01}$ | 5.58 | 5.20 | 7.35 | |
| Comparative example 3 | $Mg_{3.2}Sb_{1.5}Bi_{0.49}Te_{0.01}$ | 8.72 | - | - | Peeling |
| Comparative example 4 | $Mg_{3.2}Sb_{1.0}Bi_{0.99}Te_{0.01}$ | 8.67 | - | - | Peeling |

INDUSTRIAL APPLICABILITY

The thermoelectric conversion elements of the present disclosure can be used in a variety of applications, including applications of thermoelectric conversion elements of the related art.

REFERENCE SIGNS LIST

10a, 10b thermoelectric conversion element
11 thermoelectric conversion layer
11a first surface
12 metal layer
20a P-type thermoelectric conversion element
31 electrode
70 heat source
100, 200, 300, 400 thermoelectric conversion module
500 thermoelectric conversion system

**Claims**

1.  A thermoelectric conversion element comprising:

a thermoelectric conversion layer that comprises a thermoelectric conversion material comprising Mg and at least one selected from the group consisting of Sb and Bi; and
a metal layer, wherein
the thermoelectric conversion layer comprises a first surface that is in contact with the metal layer, and
in an instance where a cross section of the thermoelectric conversion layer and the metal layer in a thickness direction of the metal layer is observed by energy dispersive X-ray spectroscopy, an arithmetic mean roughness Ra of the first surface in the cross section satisfies a first condition expressed as $Ra \leq 4.2 \ \mu m$.

2. The thermoelectric conversion element according to claim 1, wherein the metal layer comprises Cu.

3. The thermoelectric conversion element according to claim 1, wherein the arithmetic mean roughness Ra of the first surface satisfies a second condition expressed as $0.05 \ \mu m \leq Ra$.

4. The thermoelectric conversion element according to claim 1, wherein the thermoelectric conversion material has a $La_2O_3$ crystal structure.

5. The thermoelectric conversion element according to claim 1, wherein the thermoelectric conversion material further comprises Te.

6. The thermoelectric conversion element according to claim 1, wherein the thermoelectric conversion material has a composition represented by $Mg_{3+m}R_aT_bSb_{2-e-c}Bi_cZ_e$, where

the element R is at least one element selected from the group consisting of Ca, Sr, Ba, and Yb,
the element T is at least one element selected from the group consisting of Mn and Zn,
the element Z is at least one element selected from the group consisting of Te, Se, Sc, Y, and La,
a value of m satisfies $-0.39 \leq m \leq 0.42$,
a value of a satisfies $0 \leq a \leq 0.12$,
a value of b satisfies $0 \leq b \leq 0.48$,
a value of c satisfies $0 \leq c \leq 1.6$, and
a value of e satisfies $0.001 \leq e \leq 0.06$.

7. A thermoelectric conversion module comprising:

a P-type thermoelectric conversion element;
an N-type thermoelectric conversion element; and
an electrode electrically connecting a first end portion of the P-type thermoelectric conversion element to a first end portion of the N-type thermoelectric conversion element, wherein
the N-type thermoelectric conversion element is the thermoelectric conversion element according to claim 1.

8. A thermoelectric conversion system comprising:

the thermoelectric conversion module according to claim 7; and
a heat source disposed adjacent to the electrode.

9. A method for generating electrical power, the method comprising generating electrical power by applying a temperature difference to the thermoelectric conversion module according to claim 7 by using heat from the heat source.

10. A thermoelectric conversion material comprising Mg and at least one selected from the group consisting of Sb and Bi, wherein

the thermoelectric conversion material comprises at least one surface that is to be in contact with an outside of the thermoelectric conversion material, the at least one surface having an arithmetic mean roughness Ra that satisfies a condition expressed as $Ra \leq 5.2 \ \mu m$, and
the arithmetic mean roughness Ra is determined in accordance with JIS B 0601:2013 and JIS B 0633:2001.

11. A method for manufacturing a thermoelectric conversion element, the method comprising:

adjusting an arithmetic mean roughness Ra of a first surface of a thermoelectric conversion layer that comprises a thermoelectric conversion material comprising Mg and at least one selected from the group consisting of Sb and Bi; and

forming a metal layer in contact with the first surface, wherein

in an instance where a cross section of the thermoelectric conversion layer and the metal layer in a thickness direction of the metal layer is observed by energy dispersive X-ray spectroscopy, the arithmetic mean roughness Ra of the first surface in the cross section satisfies a condition expressed as Ra ≤ 4.2 μm.

# FIG. 1

# FIG. 2

## FIG. 3

```
        ( START )
           │
           ▼
S1 ┌─────────────────────────┐
   │  OBTAIN EDX IMAGE OF     │
   │  SINGLE ELEMENT          │
   └─────────────────────────┘
           │
           ▼
S2 ┌─────────────────────────┐
   │  GRAYSCALE CONVERSION    │
   └─────────────────────────┘
           │
           ▼
S3 ┌─────────────────────────┐
   │  BINARIZATION PROCESS    │
   └─────────────────────────┘
           │
           ▼
S4 ┌─────────────────────────┐
   │  DENOISING PROCESS       │
   └─────────────────────────┘
           │
           ▼
S5 ┌─────────────────────────┐
   │  OBTAIN INTERFACE        │
   │  COORDINATE POINT SEQUENCE│
   └─────────────────────────┘
           │
           ▼
S6 ┌─────────────────────────┐
   │  CALCULATE ARITHMETIC MEAN│
   │  ROUGHNESS Ra            │
   └─────────────────────────┘
           │
           ▼
        (  END  )
```

## FIG. 4

# FIG. 5

# FIG. 6

START

S11 — PREPARE THERMOELECTRIC CONVERSION MATERIAL

S12 — ADJUST SURFACE ROUGHNESS OF FIRST SURFACE 11a OF THERMOELECTRIC CONVERSION LAYER 11

S13 — FORM METAL LAYER 12

END

# FIG. 7

# FIG. 8

# FIG. 9

## FIG. 10

## FIG. 11

## FIG. 12

## FIG. 13

## FIG. 14

## INTERNATIONAL SEARCH REPORT

| | International application No. |
|---|---|
| | **PCT/JP2023/041705** |

| A. | CLASSIFICATION OF SUBJECT MATTER |
|---|---|

*H10N 10/817*(2023.01)i; *C22C 23/00*(2006.01)i; *C22F 1/06*(2006.01)i; *H10N 10/01*(2023.01)i; *H10N 10/852*(2023.01)i
FI:   H10N10/817; C22C23/00; C22F1/06; H10N10/01; H10N10/852

According to International Patent Classification (IPC) or to both national classification and IPC

| B. | FIELDS SEARCHED |
|---|---|

Minimum documentation searched (classification system followed by classification symbols)

H10N10/817; C22C23/00; C22F1/06; H10N10/01; H10N10/852

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | WO 2020/003554 A1 (PANASONIC INTELLECTUAL PROPERTY MANAGEMENT CO., LTD.) 02 January 2020 (2020-01-02)<br>      paragraphs [0016]-[0060], fig. 1-4 | 1-11 |
| Y | JP 2013-542578 A (PANASONIC CORPORATION) 21 November 2013 (2013-11-21)<br>      paragraphs [0002], [0003], [0031], [0032], [0036], [0037], [0050], [0051], [0086], fig. 1, 5, 17 | 1-11 |
| Y | JP 2003-197981 A (KYOCERA CORPORATION) 11 July 2003 (2003-07-11)<br>      paragraphs [0013]-[0022], [0050]-[0087], [0093], [0094], fig. 1-3 | 1-11 |

☐ Further documents are listed in the continuation of Box C.      ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **01 February 2024** | **13 February 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2023/041705**

| Patent document cited in search report | | | Publication date (day/month/year) | Patent family member(s) | | | Publication date (day/month/year) |
|---|---|---|---|---|---|---|---|
| WO | 2020/003554 | A1 | 02 January 2020 | US paragraphs [0043]-[0092], fig. 1-4 EP CN | 2020/0006616 3817073 110998882 | A1 A1 A | |
| JP | 2013-542578 | A | 21 November 2013 | US paragraphs [0002], [0003], [0053], [0054], [0058], [0059], [0072], [0073], [0108]-[0110], fig. 1, 5, 17 WO EP CN | 2013/0199593 2012/066788 2641281 103140949 | A1 A2 A2 A | |
| JP | 2003-197981 | A | 11 July 2003 | (Family: none) | | | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 111613715
- CN 110635020
- WO 2020003554 A
- JP 2022523127 W

**Non-patent literature cited in the description**

- **X. WU**. *Acta Mater.*, 2022, vol. 226, 117616